# EUROPÄISCHE PATENTSCHRIFT

(11) **EP 3 010 741 B1**
(45) Veröffentlichungstag und Bekanntmachung des Hinweises auf die Patenterteilung: **21.08.2019**
(21) Anmeldenummer: 14731230.0
(22) Anmeldetag: 16.06.2014
(51) Int. Cl.: B60J 7/00, B60Q 3/208, B32B 17/10, B62D 25/06

(54) **ANORDNUNG ZUM VERSCHLIESSEN EINER ÖFFNUNG EINES FAHRZEUGS MIT EINER SCHEIBE UND EINER LICHTLEITERFOLIE**
ARRANGEMENT FOR CLOSING AN OPENING IN A VEHICLE WITH A PANE AND A LIGHT-GUIDING SHEET
AGENCEMENT POUR FERMER UNE OUVERTURE D'UN VÉHICULE AVEC UNE VITRE ET UN FILM GUIDE DE LUMIÈRE

(30) Priorität: 19.06.2013 DE 102013010163
(43) Veröffentlichungstag der Anmeldung: 27.04.2016
(73) Patentinhaber: Webasto SE, 82131 Stockdorf (DE)
(72) Erfinder: DEPPE, Michael, 82223 Eichenau (DE)
(74) Vertreter: Schwan Schorer & Partner mbB
(86) Internationale Anmeldenummer: PCT/EP2014/062556
(87) Internationale Veröffentlichungsnummer: WO 2014/202526

(56) Entgegenhaltungen:
- EP-A1- 1 493 557
- WO-A1-2007/085599
- DE-A1- 10 204 359
- DE-A1-102004 007 988
- US-A1- 2006 209 551

## Beschreibung

Die vorliegende Erfindung betrifft eine Anordnung zum Verschließen einer Öffnung eines Fahrzeugdachs gemäß dem Oberbegriff des Anspruchs 1.

Eine gattungsgemäße Anordnung ist beispielsweise aus der DE 10 2004 007 988 A1 oder WO2007/085599 A1 bekannt.

Bekannte Anordnungen zum Verschließen eines Fahrzeugdachs, die eine transparente Scheibe aufweisen, gewährleisten, dass Tageslicht in einen Fahrzeuginnenraum einfallen kann, sodass der Fahrzeuginnenraum im Vergleich zu einem Fahrzeugdach ohne Scheibe besser ausgeleuchtet ist.

Es ist Aufgabe der vorliegenden Erfindung, eine Anordnung zum Verschließen einer Öffnung eines Fahrzeugdachs mit einer transparenten Scheibe zu schaffen, mittels weicher die Ausleuchtung des Fahrzeuginnenraums weiter verbessert wird.

Diese Aufgabe wird durch eine Anordnung gemäß dem Kennzeichen des Anspruchs 1 gelöst.

Erfindungsgemäß ist an der Scheibe der Anordnung eine Lichtleiterfolie vorgesehen, die an einer einem Fahrzeuginnenraum zugewandten Unterseite der Scheibe angeordnet ist. Die Lichtleiterfolie bietet den wesentlichen Vorteil, dass die transparente Scheibe selbst wie eine homogene Lichtquelle erscheint, wodurch eine angenehme ambiente Ausleuchtung des Fahrzeuginnenraums auch nachts oder bei reduzierter Sonneneinstrahlung erzielt werden kann. Dies wird erreicht, indem Licht einer Lichtquelle der Anordnung in die Lichtleiterfolie eingekoppelt wird. Die Lichtleiterfolie ist so ausgebildet und angeordnet, dass sie das eingekoppelte Licht in den Fahrzeuginnenraum (12) abstrahlt. Dabei gewährleistet die Verwendung einer Lichtleiterfolie, die transparent oder zumindest teiltransparent oder transluzent ausgebildet ist, dass Tageslicht oder externes Kunstlicht weiterhin durch die transparente Scheibe in den Fahrzeuginnenraum fallen kann. Eine erfindungsgemäße Anordnung kann dazu dienen, die Öffnung eines Fahrzeugdachs als Festverglasung starr zu verschließen. Alternativ kann vorgesehen sein, dass die

Öffnung des Fahrzeugdachs öffenbar ausgestaltet ist, dass also die transparente Scheibe Teil eines verlagerbaren Deckels ist, welcher zur Freigabe der Öffnung des Fahrzeugdachs verlagerbar ausgestaltet ist.

Die Lichtleiterfolie ist Teil eines Folienverbunds, der auf die Unterseite der Scheibe aufgeklebt oder auflaminiert ist. Dies bietet den Vorteil, dass neben der lichtleitenden Funktion auch weitere Funktionen durch den Folienverbund wahrgenommen werden können, wie beispielsweise ein Schutz der Lichtleiterfolie des Folienverbunds gegen ein Zerkratzen.

Weiter bevorzugte Ausgestaltungen ergeben sich aus den Unteransprüchen.

Vorzugsweise kann ein entsprechender Folienverbund eine Splitterschutzfolie aufweisen, sodass der Folienverbund neben der Beleuchtungsfunktion auch einen Insassenschutz bietet. Dies ist insbesondere deshalb wichtig, da die transparente Scheibe, die aus Verbundglas, einem Einscheibensicherheitsglas oder aus einem transparenten Kunststoff bestehen kann, im Fall eines Unfalls zu Bruch gehen kann. Dann wird durch die Splitterschutzfolie gewährleistet, dass Splitter der transparenten Scheibe (oder die komplette Scheibe) nicht in den Fahrzeuginnenraum gelangen können. Um diesen Schutz weiter zu verbessern, kann dabei der Folienverbund inklusive der Splitterschutzfolie in einem Randbereich der transparenten Scheibe verankert und direkt oder indirekt mit der Fahrzeugkarosserie verbunden sein. Beispielsweise kann der Folienverbund in eine Randumschäumung eingeschäumt und ergänzend mechanisch (kraftschlüssig) befestigt sein. Die Splitterschutzfolie ist dabei vorzugsweise an der dem Fahrzeuginnenraum zugewandten Seite des Folienverbunds angeordnet, sodass sie beispielsweise auch die Lichtleiterfolie vor einem Zerkratzen schützt.

Vorzugsweise beinhaltet ein entsprechender Folienverbund eine IR-Schutzfolie (Infrarotschutzfolie), die Infrarotstrahlung, also Wärmestrahlung, mindestens teilweise absorbiert oder reflektiert. Dies bietet den Vorteil, dass der Temperaturanstieg im Fahrzeuginnenraum durch Sonneneinstrahlung reduziert wird. Die IR-Schutzfolie ist vorzugsweise an einer der Scheibe zugewandten Seite des Folienverbunds angeordnet, bildet also in Blickrichtung auf das Fahrzeugdach die erste Schicht des Folienverbunds.

In einer weiteren bevorzugten Ausgestaltung der vorliegenden Erfindung sind im Bereich der transparenten Scheibe ferner Solarzellen vorgesehen. Diese können in den Folienverbund integriert sein, wobei sich insbesondere organische Solarzellen anbieten, die als Schicht auf eine Folie des Folienverbunds aufgebracht, beispielsweise aufgedampft sein können, oder der Folienverbund kann eine entsprechende Folie aufweisen, welche die organischen Solarzellen beinhaltet. Alternativ können auch kristalline oder amorphe Solarzellen vorgesehen sein, die vorzugsweise zwischen dem Folienverbund und der transparenten Scheibe angeordnet sind. Dies bietet den Vorteil, dass die kristallinen oder amorphen Solarzellen zusammen mit dem Folienverbund auf die transparente Scheibe auflaminiert werden können. Die Solarzellen werden daher mittels des Folienverbundes an der transparenten Scheibe fixiert und durch diesen geschützt.

Gemäß einer weiteren erfindungsgemäßen Ausgestaltung der vorliegenden Erfindung ist eine Lichteinkopplungsvorrichtung vorgesehen, mittels welcher das Licht der Lichtquelle der Anordnung in die Lichtleiterfolie einkoppelbar ist. Je nach Art der Lichtquelle, bei welcher es sich vorzugsweise um eine elektrische Lichtquelle in Form mindestens einer Lampe oder LED handelt, kann eine solche Lichteinkoppiungsvorrichtung beispielsweise Linsen zur Fokussierung des Lichts auf eine Seitenkante der Lichtleiterfolie beinhalten. Dies bietet den Vorteil, dass das Licht solcher divergenten Lichtquellen effizienter in die Lichtleiterfolie eingekoppelt wird. Die Lichteinkopplungsvorrichtung kann darüber hinaus oder alternativ auch Prismen oder Prismenkoppler aufweisen, um das Licht in die Lichtleiterfolie einzukoppeln.

Die Lichtleiterfolie ist so ausgebildet, dass sie eingekoppeltes Licht in Richtung des Fahrzeuginnenraums auskoppelt.

Dabei kann die Lichtleiterfolie insbesondere so ausgebildet sein, dass Lichtstrahlen, die innerhalb der Lichtleiterfolie in einer Richtung vom Fahrzeuginnenraum weg verlaufen, von der Grenzfläche der Lichtleiterfolie oder eines Lichtleiters innerhalb der Lichtleiterfolie, die dem Fahrzeuginnenraum abgewandt ist, überwiegend reflektiert werden. Die Lichtleiterfolie kann weiterhin vorzugsweise so ausgebildet sein, dass Lichtstrahlen, die innerhalb der Lichtleiterfolie (oder eines Lichtleiters innerhalb der Lichtleiterfolie) in einer Richtung zum Fahrzeuginnenraum hin oder parallel zur Lichtleiterfolie verlaufen, durch die Grenzfläche der Lichtleiterfolie, die dem Fahrzeuginnenraum zugewandt ist, überwiegend transmittiert werden. Dieses Verhalten der Lichtleiterfolie, also die Reflektion des sichtbaren Lichts an der Fläche der Lichtleiterfolie, die dem Fahrzeuginnenraum abgewandt ist, in die Lichtleiterfolie zurück, und die Transmission des sichtbaren Lichts durch die Fläche der Lichtleiterfolie, die dem Fahrzeuginnenraum zugeordnet ist, aus der Lichtleiterfolie heraus, führt zu einer gezielten Beleuchtung des Fahrzeuginnenraums. Dies kann dadurch erreicht werden, dass an der äußeren Fläche eines Lichtleiters der Lichtleiterfolie die Bedingungen so ausgestaltet sind, dass der Winkel der Totalreflektion für sichtbares Licht möglichst groß ist. Dieser Winkel der Totalreflektion, welcher dem Einfallswinkel (relativ zum Einfallslot) entspricht, bei welchem ein Lichtstrahl parallel zur Grenzfläche verläuft, wird festgelegt durch die Brechungsindizes einerseits innerhalb des Lichtleiters der Lichtleiterfolie und andererseits des optischen Materials, welches dem Lichtleiter benachbart liegt. Entsprechende Lichtleiterfolien, die auf einer Seite, zum Beispiel die Seite der Lichtleiterfolie, die dem Fahrzeuginnenraum abgewandt angeordnet wird, möglichst effizient Licht, welches in der Lichtleiterfolie "eingeschlossen" werden soll, reflektieren, sind bekannt. Damit aber das in die Lichtleiterfolie eingekoppelte Licht nicht nur zum Fahrzeuginnenraum hin reflektiert wird, sondern auch zu diesem hin ausgekoppelt wird, kann beispielsweise vorgesehen sein, dass die Fläche des Lichtleiters, die dem Fahrzeuginnenraum zugeordnet ist, eine Struktur wie beispielsweise eine Prismenstruktur aufweist, um die Lichteinkopplung in den Fahrzeuginnenraum zu verbessern. Weiterhin oder alternativ können in der Lichtleiterfolie Streukörper vorgesehen sein, welche die Lichteinstrahlung in den Fahrzeuginnenraum verstärken. Da die Grenzfläche der Lichtleiterfolie, die dem Fahrzeuginnenraum zugewandt ist, so ausgestaltet ist, dass die Bedingung für Totalreflektion für einen großen Winkelbereich von Einfallswinkeln von Licht zum Lot der Grenzfläche nicht erfüllt ist, wird insgesamt ein großer Anteil des eingekoppelten Lichts zum Fahrzeuginnenraum hin gelenkt.

Während als Lichtquelle grundsätzlich verschiedene Lichtquellen, wie Glühlampen, vorgesehen sein können, ist die Ausgestaltung der Anordnung mit mindestens einer LED (Licht emittierende Diode) besonders bevorzugt, da hier einerseits die Wärmeentwicklung durch die Lichtquelle und andererseits der Stromverbrauch durch die Lichtquelle reduziert wird.

Vorzugsweise ist die Lichtquelle im Bereich eines Rands der Scheibe angeordnet. Ist an der Scheibe eine Randumschäumung vorgesehen, so kann die Lichtquelle in diese Randumschäumung integriert sein. Grundsätzlich ist es von Vorteil, wenn die Lichtquelle eine bevorzugte Abstrahlrichtung aufweist, und diese so ausgerichtet eingebaut wird, dass diese Abstrahlrichtung bereits auf die seitliche Kante der Lichtleiterfolie ausgerichtet ist. Dies bedeutet, dass die Lichtquelle mit ihrer maximalen Abstrahlrichtung parallel zur Lichtleiterfolie ausgerichtet und auf deren Seitenkante zugewandt ist.

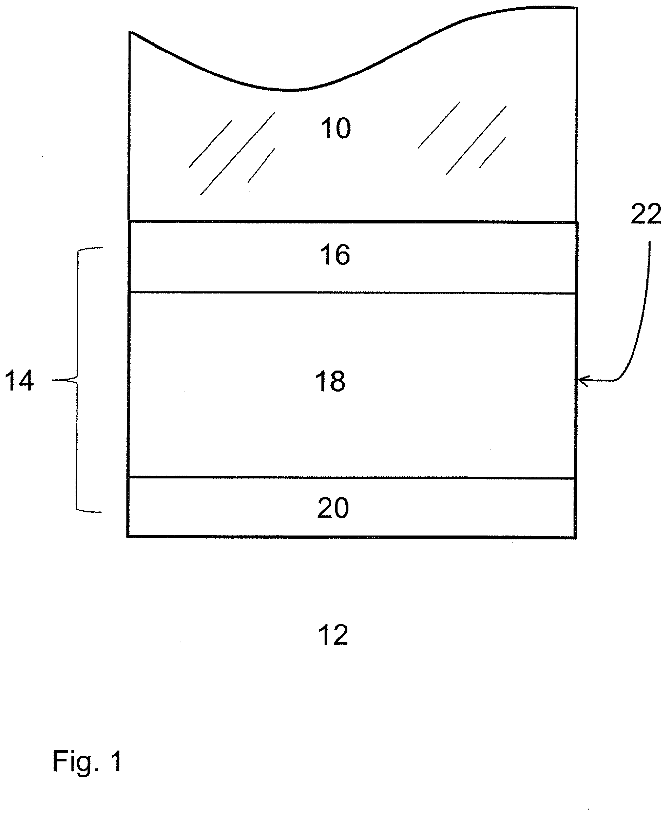

Im Folgenden wird die Erfindung anhand der beigefügten Zeichnungen beispielhaft näher erläutert. Dabei zeigt
- Fig. 1: einen Querschnitt durch einen Folienverbund, wie er an der transparenten Scheibe einer erfindungsgemäßen Anordnung angeordnet ist.

Fig. 1 zeigt eine transparente Scheibe 10 einer Anordnung zum Verschließen einer Öffnung eines Fahrzeugdachs. Die Scheibe 10 kann dabei aus Glas (Einscheibensicherheitsglas, ESG, oder Verbundglas) ausgebildet sein, oder aus einem transparenten Kunststoff, wie beispielsweise Acryl. Die abgebildete Anordnung verschließt eine Öffnung eines Fahrzeugdachs, wobei ein Fahrzeuginnenraum 12 des Fahrzeugs im unteren Bildbereich liegt. Unterhalb der transparenten Scheibe 10 ist erfindungsgemäß ein Folienverbund 14 angeordnet, also beispielsweise aufgeklebt oder auflaminiert. Ein entsprechender Kleber zwischen dem Folienverbund 14 und der Scheibe 10 ist nicht dargestellt. Der Kleber kann beispielsweise mittels einer Schmelzklebefolie eingebracht werden. Der Folienverbund 14 besteht aus einer Schichtabfolge von der transparenten Scheibe 10 zum Fahrzeuginnenraum 12 hin mit einer IR reflektierenden oder absorbierenden IR-Schutzfolie 16, einer Lichtleiterfolie 18 (vorzugsweise aus Kunststoff) und einer Splitterschutzfolie 20. Die IR-Schutzfolie 16 dient dabei der Reduzierung der Aufheizung des Fahrzeuginnenraums 12 durch Sonneneinstrahlung. Die dem Fahrzeuginnenraum 12 zugewandte Splitterschutzfolie 20 dient einerseits dem Schutz der Fahrzeuginsassen vor Splittern, die sich im Falle eines Unfalls aus der transparenten Scheibe 10 lösen können. Andererseits dient die Splitterschutzfolie 20 auch dem Schutz der Lichtleiterfolie 18 und der IR-Schutzfolie 16 vor einem Zerkratzen. Hierzu kann die Splitterschutzfolie 20 mit einer Kratzfestbeschichtung ausgestaltet sein. Die Splitterschutzfolie kann auch einlagig ausgebildet sein und aufgrund ihrer Konsistenz sowohl die Splitterschutzfunktion als auch die Kratzschutzfunktion wahrnehmen. Sie kann alternativ auch mehrlagig ausgebildet sein, um den Splitterschutz zu optimieren, bzw. den Splitterschutz mit dem Kratzschutz zu versehen oder zu ergänzen.

Die Beleuchtung des Fahrzeuginnenraums erfolgt erfindungsgemäß durch eine Lichtquelle (in der Fig. 1 nicht dargestellt) deren Licht seitlich, also in Bildrichtung von links oder rechts oder von beiden Seiten in die Lichtleiterfolie 18 eingekoppelt wird. Das Licht, beispielsweise von LEDs oder einer oder mehreren Glühlampen, wird dabei über Linsen oder Prismen auf eine Seitenfläche oder Seitenkante 22 der Lichtleiterfolie 18 fokussiert bzw. in diese eingekoppelt. Die Einkopplung kann auch von zwei gegenüberliegenden Seitenkanten erfolgen. Wird Licht nur von einer Seitenkante 22 eingekoppelt, so kann die gegenüberliegende Seitenkante so ausgebildet sein, dass sie sichtbares Licht reflektiert, damit das eingeschlossene Licht hier nicht austreten kann. Alternativ kann hierzu auch ein separates Spiegelelement vorgesehen sein.

Die Lichtleiterfolie 18 ist so ausgebildet, dass ihre obere Oberfläche (der Scheibe 10 zugewandt) möglichst effizient eingekoppeltes Licht reflektiert. Umgekehrt ist ihre untere Oberfläche (also die dem Fahrzeuginnenraum 12 zugewandte Fläche) so ausgebildet, dass eingekoppeltes Licht möglichst effizient zum Fahrzeuginnenraum 12 transmittiert, also ausgekoppelt wird. Damit das ausgekoppelte Licht tatsächlich den Fahrzeuginnenraum 12 erreicht, ist die Splitterschutzfolie 20 transparent oder transluzent ausgebildet. Damit weiterhin Licht von außen, also in der Fig. 1 von oben durch die Anordnung in den Fahrzeuginnenraum 12 einfallen kann, ist auch die IR-Schutzfolie 16 und die Lichtleiterfolie 18 transparent oder transluzent ausgebildet. Damit ist gewährleistet, dass Tageslicht durch die Anordnung hindurch den Fahrzeuginnenraum 12 beleuchtet. Umgekehrt ermöglicht die lichtleitende Kunststofffolie eine flächige, homogene und ambiente Ausleuchtung des Fahrzeuginnenraums 12 mit Kunstlicht.

### Bezugszeichenliste

- 10: Splitterschutzfolie
- 12: Fahrzeuginnenraum
- 14: Folienverbund
- 16: IR-Schutzfolie
- 18: Lichtleiterfolie
- 20: Splitterschutzfolie
- 22: Seitenkante von 18

## Patentansprüche

1. Anordnung zum Verschließen einer Öffnung eines Fahrzeugdachs, wobei die Anordnung eine transparente Scheibe (10) aufweist,
**dadurch gekennzeichnet, dass**
an der Scheibe (10) eine Lichtleiterfolie (18) an einer einem Fahrzeuginnenraum (12) zugewandten Unterseite der Scheibe (10) angeordnet ist, in welche Licht einer Lichtquelle der Anordnung einkoppelbar ist, und die so ausgebildet ist, dass sie das eingekoppelte Licht in den Fahrzeuginnenraum (12) abstrahlt, wobei die Lichtleiterfolie (18) Teil eines Folienverbunds (14) ist, der auf die Unterseite der Scheibe (10) aufgeklebt oder auflaminiert ist.

2. Anordnung nach Anspruch 1 **dadurch gekennzeichnet, dass** der Folienverbund (14) eine Splitterschutzfolie (20) aufweist.

3. Anordnung nach Anspruch 2, **dadurch gekennzeichnet, dass** die Splitterschutzfolie (20) an der dem Fahrzeuginnenraum (12) zugewandten Seite des Folienverbunds angeordnet ist.

4. Anordnung nach einem der vorhergehenden Ansprüche, **dadurch gekennzeichnet, dass** der Folienverbund (14) eine IR-Schutzfolie (16) aufweist, welche IR-Strahlung mindestens teilweise absorbiert oder reflektiert, wobei die IR-Schutzfolie (16) vorzugsweise an einer der Scheibe (10) zugewandten Seite des Folienverbunds (14) angeordnet ist.

5. Anordnung nach einem der vorhergehenden Ansprüche, **dadurch gekennzeichnet, dass** der Folienverbund (14) eine Schicht oder eine Folie aufweist, welche organische Solarzellen beinhaltet.

6. Anordnung nach einem der vorhergehenden Ansprüche 1 bis 4, **dadurch gekennzeichnet, dass** zwischen dem Folienverbund (14) und der Scheibe (10) kristalline oder amorphe Solarzellen angeordnet sind.

7. Anordnung nach einem der vorhergehenden Ansprüche, **dadurch gekennzeichnet, dass** eine Lichteinkoppelungsvorrichtung vorgesehen ist, mittels welcher das Licht der Lichtquelle in eine Seiten kante (22) der Lichtleiterfolie (18) eingekoppelbar ist, und die Lichtleiterfolie (18) so ausgebildet ist, dass sie das eingekoppelte Licht in Richtung des Fahrzeuginnenraums (12) auskoppelt.

8. Anordnung nach Anspruch 7, **dadurch gekennzeichnet, dass**, die Lichtleiterfolie (18) so ausgebildet ist, dass Lichtstrahlen, die innerhalb der Lichtleiterfolie (18) in einer Richtung vom Fahrzeuginnenraum (12) weg verlaufen, von der Grenzfläche der Lichtleiterfolie, die dem Fahrzeuginnenraum (12) abgewandt ist, überwiegend reflektiert werden, und Lichtstrahlen, die innerhalb der Lichtleiterfolie (18) in einer Richtung zum Fahrzeuginnenraum (12) hin oder parallel zur Lichtleiterfolie (18) verlaufen, durch die Grenzfläche der Lichtleiterfolie, die dem Fahrzeuginnenraum (12) zugewandt ist, in den Fahrzeuginnenraum (12) transmittiert werden.

9. Anordnung nach Anspruch 7 oder 8, **dadurch gekennzeichnet, dass** die Lichtquelle mindestens eine LED aufweist.

10. Anordnung nach einem der Ansprüche 7 bis 9, **dadurch gekennzeichnet, dass** die Lichtquelle im Bereich eines Rands der Scheibe (10) angeordnet ist, vorzugsweise in einer Randumschäumung der Scheibe (10).

## Claims

1. Arrangement for closing an opening in a vehicle roof, the arrangement having a transparent pane (10),
**characterized in that**
arranged on the pane (10), on an underside of the pane (10) that is facing the passenger compartment (12), is a light guide film (18), into which light from a light source of the arrangement can be coupled, and which is formed in such a way that it emits the incoupled light into the passenger compartment (12), the light guide film (18) being part of a film assembly (14), which is adhesively attached on or laminated to the underside of the pane (10).

2. Arrangement according to Claim 1, **characterized in that** the film assembly (14) has an anti-shatter protective film (20).

3. Arrangement according to Claim 2, **characterized in that** the anti-shatter protective film (20) is arranged on the side of the film assembly that is facing the passenger compartment (12).

4. Arrangement according to one of the preceding claims, **characterized in that** the film assembly (14) has an IR protective film (16), which at least partially absorbs or reflects IR radiation, the IR protective film (16) preferably being arranged on a side of the film assembly (14) that is facing the pane (10).

5. Arrangement according to one of the preceding claims, **characterized in that** the film assembly (14) has a layer or a film that comprises organic solar cells.

6. Arrangement according to one of the preceding Claims 1 to 4, **characterized in that** crystalline or amorphous solar cells are arranged between the film assembly (14) and the pane (10).

7. Arrangement according to one of the preceding claims, **characterized in that** a light-incoupling device is provided, by means of which the light from the light source can be coupled into a side edge (22) of the light guide film (18), and the light guide film (18) is formed in such a way that it couples the incoupled light out in the direction of the passenger compartment (12).

8. Arrangement according to Claim 7, **characterized in that** the light guide film (18) is formed in such a way that rays of light that run within the light guide film (18) in a direction away from the passenger compartment (12) are predominantly reflected by the boundary surface of the light guide film that is facing away from the passenger compartment (12), and rays of light that run within the light guide film (18) in a direction toward the passenger compartment (12) or parallel to the light guide film (18) are transmitted by the boundary surface of the light guide film that is facing the passenger compartment (12) into the passenger compartment (12).

9. Arrangement according to Claim 7 or 8, **characterized in that** the light source has at least one LED.

10. Arrangement according to one of Claims 7 to 9, **characterized in that** the light source is arranged in the region of an edge of the pane (10), preferably in a foam edging of the pane (10).

## Revendications

1. Agencement pour fermer une ouverture dans un toit de véhicule, dans lequel l'agencement comporte une vitre transparente (10),
**caractérisé en ce qu'**une feuille guide de lumière (18) dans laquelle la lumière d'une source lumineuse de l'agencement peut être injectée est disposée sur la vitre (10), sur un côté inférieur de la vitre (10) qui est orienté vers un habitacle (12) du véhicule, et qui est conçue de manière à émettre dans l'habitacle (12) du véhicule la lumière injectée, dans lequel la feuille guide de lumière (18) fait partie d'une feuille composite (14) qui est collée ou stratifiée sur le côté inférieur de la vitre (10).

2. Agencement selon la revendication 1, **caractérisé en ce que** la feuille composite (14) présente une feuille de protection contre les éclats (20).

3. Agencement selon la revendication 2, **caractérisé en ce que** la feuille de protection contre les éclats (20) est disposée sur le côté de la feuille composite qui est orienté vers l'habitacle (12) du véhicule.

4. Agencement selon l'une des revendications précédentes, **caractérisé en ce que** la feuille composite (14) présente une feuille de protection contre les rayonnements IR (16) qui absorbe ou reflète au moins partiellement les rayonnements IR, dans lequel la feuille de protection contre les rayonnements IR (16) est de préférence disposée sur un côté de la feuille composite (14) qui est orienté vers la vitre (10).

5. Agencement selon l'une des revendications précédentes, **caractérisé en ce que** la feuille composite (14) comprend une couche ou une feuille qui renferme des cellules solaires organiques.

6. Agencement selon l'une des revendications précédentes 1 à 4, **caractérisé en ce que** des cellules solaires cristallines ou amorphes sont disposées entre la feuille composite (14) et la vitre (10).

7. Agencement selon l'une des revendications précédentes, **caractérisé en ce qu'**il est prévu un dispositif d'injection de lumière au moyen duquel la lumière de la source lumineuse peut être injectée dans un bord latéral (22) de la feuille guide de lumière (18) et la feuille guide de lumière (18) est conçue pour extraire la lumière injectée dans direction de l'habitacle (12) du véhicule.

8. Agencement selon la revendication 7, **caractérisé en ce que** la feuille guide de lumière (18) est conçue de manière à ce que des faisceaux lumineux qui se propagent à l'intérieur de la feuille guide de lumière (18) dans une direction s'éloignant de l'habitacle (12) du véhicule soient principalement réfléchis par la surface limite de la feuille guide de lumière qui orientée à l'opposé de l'habitacle (12) du véhicule, et à ce que des faisceaux lumineux qui se propagent à l'intérieur de la feuille guide de lumière (18) dans une direction orientée vers l'habitacle (12) du véhicule ou parallèlement à la feuille guide de lumière (18) soient transmis dans l'habitacle (12) du véhicule à travers la surface limite de la feuille guide de lumière qui est orientée vers l'habitacle (12) du véhicule.

9. Agencement selon la revendication 7 ou 8, **caractérisé en ce que** la source lumineuse comprend au moins une LED.

10. Agencement selon l'une des revendications 7 à 9, **caractérisé en ce que** la source lumineuse est disposée dans la zone d'un bord de la vitre (10), de préférence dans une mousse de bord entourant la vitre (10).
